Europäisches Patentamt

European Patent Office

Office européen des brevets

(19)

(11) **EP 0 552 575 B1**

(12) **FASCICULE DE BREVET EUROPEEN**

(45) Date de publication et mention
de la délivrance du brevet:
**02.12.1998 Bulletin 1998/49**

(51) Int Cl.⁶: $G06K\ 9/62$, $G06F\ 17/30$

(21) Numéro de dépôt: **92403484.6**

(22) Date de dépôt: **21.12.1992**

(54) **Procédé de segmentation polytomique**

Mehrfachteilungsegmentierungsverfahren

Procedure of polytomic segmentation

(84) Etats contractants désignés:
**DE GB IT**

(30) Priorité: **26.12.1991 FR 9116160**

(43) Date de publication de la demande:
**28.07.1993 Bulletin 1993/30**

(73) Titulaire: **THOMSON-CSF**
**75008 Paris (FR)**

(72) Inventeur: **Nivelle, François**
**F-92402 Courbevoie Cedex (FR)**

(74) Mandataire: **Chaverneff, Vladimir et al**
**Thomson-CSF Propriété Intellectuelle,**
**13, Avenue du Président Salvador Allende**
**94117 Arcueil Cédex (FR)**

(56) Documents cités:
**US-A- 4 658 429** **US-A- 4 682 365**

- **PROCEEDINGS OF EUSIPCO 88 FOURTH EUROPEAN SIGNAL PROCESSING CONFERENCE, NORTH HOLLAND AMSTERDAM, NL vol. 3, 5 Septembre 1988, GRENOBLE, FR pages 1621 - 1624 T.N.DASKALAKIS, A.G.HEATON, C.N.DASKALAKIS 'A GRAPH-THEORETIC ALGORITHM FOR UNSUPERVISED IMAGE SEGMENTATION'**
- **IEEE TRANSACTIONS ON PATTERN ANALYSIS AND MACHINE INTELIGENCE, IEEE COMPUTER SOCIETY PRESS vol. 13, no. 4, Avril 1991, NEW YORK, US pages 340 - 354 , XP000214961 P.A.CHOU 'OPTIMAL PARTIONING FOR CLASSIFICATION AND REGRESSION TREES'**
- **PATTERN RECOGNITION, PERGAMON PRESS vol. 23, no. 12, 1990, OXFORD, UK pages 1367 - 1376 , XP000168628 T.E.FLICK ET AL 'PATTERN CLASSIFICATION USING PROJECTION PURSUIT'**
- **REVUE DE STATISTIQUE ALLIQUEE vol. 30, no. 4, 1982, pages 39 - 53 G.CELEUX, Y. LECHEVALLIER 'METHODES DE SEGMENTATION NON PARAMETRIQUES'**
- **MICHAEL R.ANDERBERG 'CLUSTER ANALYSIS FOR APPLICATIONS' 1973 , ACADEMIC PRESS INC. , NEW YORK, US**

## Description

La présente invention a pour objet un procédé de segmentation polytomique, étant bien entendu qu'elle peut inclure la segmentation dichotomique.

La segmentation, ou répartition arborescente d'individus (objets quelconques, images, systèmes, données diverses, ...) est connue sous les appellations anglaises de "decision tree" ou "tree classifier".

La segmentation polytomique est utilisée dans le domaine de l'analyse de données, de la reconnaissance de formes et de la discrimination, voire de la classification automatique de données. Les méthodes de segmentation classiques sont dites "dichotomiques". L'emploi de ces méthodes sur des variables explicatives (représentation mono ou multidimensionnelle d'une mesure) fournit une interprétation booléenne de la variable à expliquer (interprétation ou type attaché à la mesure). Le résultat de ces méthodes de segmentation classiques se présente sous forme de fonctions binaires simples à employer.

Dans un processus d'analyse de données ou de discrimination séparé en une phase d'inférence (apprentissage) et une phase décisionnelle (généralisation), ces méthodes offrent des avantages certains :

- Durant la phase d'apprentissage, elles permettent de mesurer le pouvoir de discrimination des variables explicatives et de fournir une description facilement interprétable de l'analyse discriminante.
- Durant la phase de généralisation, outre l'extrême rapidité de classement (décisions à seuils en nombre fini), l'utilisateur peut influencer le classement d'un individu en incluant dans les critères de segmentation des connaissances a priori suivant l'effet qu'il recherche. La règle de décision obtenue ressemble aux méthodes de décision par approximations successives courantes dans le raisonnement humain, et permet d'élaborer entre l'utilisateur et le calculateur une interactivité très claire que l'on ne retrouve pas dans les autres méthodes de discrimination.

Pour ne citer que les plus utilisées de ces autres méthodes :

- l'analyse discriminante classique fournit des règles de décision exprimées sous forme d'expressions algébriques souvent difficiles à utiliser ;
- la méthode des K plus proches voisins est sensible à la métrique utilisée et reste, malgré les récents travaux sur des variantes plus rapides, très coûteuse en temps de calcul.

Les méthodes classiques présentent cependant les inconvénients suivants. Une méthode de segmentation classique est basée sur un découpage binaire sur la ou les variables de la mesure. Lorsque le choix ou l'interprétation à donner de la mesure est binaire (choix N° 1 ou choix N° 2), elles sont parfaitement adaptées, mais lorsqu'il faut choisir entre plusieurs choix possibles (> 2) on peut aboutir à des conflits de décision lorsque l'on refait plusieurs fois la segmentation avec des couples de choix différents, par exemple :

X est inconnu et peut appartenir aux classes N° 1, N° 2 ou N° 3
1ère phase : classe N° 1 contre classe N° 2 + classe N° 3
X est affecté à la classe N° 1
2ème phase : classe N° 2 contre classe N° 1 + classe N° 3
X est affecté aux classes N° 1 + N° 3
3ème phase : classe N° 3 contre classe N° 1 + classe N° 2
X est affecté à la classe N° 3

Une telle situation est due aux erreurs d'affectation durant chaque phase et conduit à une indétermination. De plus, on a multiplié le nombre de phases, donc le nombre de risques d'indécision et on a augmenté le coût d'une décision (en temps et/ou en matériel).

Certaines variantes choisissent à chaque pas les meilleures (au sens d'une critère spécifique) classes ou les meilleurs ensembles de classes à opposer deux à deux.

Dans ce dernier cas, on limite le nombre de phases à une seule, et on limite aussi les risques d'indécision mais on complique alors l'interprétation a posteriori de l'analyste en augmentant le nombre de tests et de segments par lesquels passe la mesure.

Une dernière contrainte des méthodes classiques vient de leur caractère non-paramétrique, c'est-à-dire que la recherche de la coupure optimale entre deux classes est faite par un comptage des données de chaque côté de la coupure, ce qui rend difficile, d'une part, la généralisation de la méthode lorsque les propriétés statistiques des mesures sont connues, et d'autre part conduit à des temps de calculs prohibitif lorsque le nombre et la richesse des mesures deviennent importants.

De telles méthodes sont par exemple décrites dans les ouvrages suivants. BREIMAN L., FRIEDMAN JH., OHLSEN RA. et STONE CJ. : "Classification and Regression trees" Editions WADSWORTH 1984. CELEUX G. et LECHEVALIER Y. :"Méthodes de segmentation non-paramétriques, Revue de statistiques appliquées" Vol. XXX, 4 pp 39-53 - 1982. FRIEDMAN JH. : " A recursive partitienary decision rule for non parametric classification" IEEE Trans-Computer pp 404-408 - Avril 1977. GUEGUEN A. et NAKACHE JP. : "Méthode de discrimination basée sur la construction d'un arbre de décision binaire", Revue statistique appliquée, XXXVI, 1 pp 19-38 - 1988. BERGONIER H. et BOUCHARENC L. : "Methode de segmentation basée sur la théorie de l'information", Prix M. DASSAULT - 1967, ou encore dans le document US-A-4 658 429.

La présente invention a pour objet un procédé de segmentation qui permette de classifier le plus simplement et le plus rapidement possible des individus en prenant en compte un ou plusieurs critères, et ce, quel que soit le nombre de classes envisagées.

Selon le procédé de l'invention a pour objet un procédé comme décrit à la revendication 1.

Selon un des aspects du procédé de l'invention, les coupures sont calculées à partir de la connaissance ou de l'estimation des paramètres descriptifs des lois statistiques voisines deux à deux.

Selon un aspect du procédé de l'invention, la segmentation est effectuée tant qu'il reste des impuretés significatives dans les classes. De façon avantageuse, on effectue à chaque nouvelle segmentation au moins un test d'arrêt imposant l'arrêt de la segmentation dès que la réduction des impuretés n'est plus effective. De préférence, les tests d'arrêt comprennent au moins l'une des vérifications suivantes: seuil d'impureté acceptable pour une classe, population minimale d'une classe, nombre maximal de classes, nombre maximal de niveaux de segmentation.

La présente invention sera mieux comprise à la lecture de la description détaillée de plusieurs modes de mise en oeuvre, pris à titre d'exemples non limitatifs.

On va d'abord décrire un algorithme de segmentation dans le cas de deux classes. Soit une base de données de N individus décrits dans un espace de représentation $R^n$ par n variables quantitatives : chaque individu $X_i$ est représenté par un vecteur $R^n, (X_{i1}, X_{i2}, X_{i3}, X_{in})$. De plus cette base de données est partitionnée en deux classes $W_1$ et $W_2$ telles que :

$$Card (W_1) = N_1 \text{ et } Card (W_2) = N_2 \text{ avec } N_1 + N_2 = N$$

Chaque individu $X_i$ est affecté a priori à l'une des deux classes $W_1$ ou $W_2$. On se place dans le cas de la théorie Bayésienne de la décision. Il faut donc introduire sur $R^n$ une mesure, fonction de décision, ou fonction caractéristique $h_j(X)$ qui permette de classer un individu X quelconque, dans une des deux classes précitées.

On utilise comme fonction de décision, les fonctions caractéristiques des densités de probabilité, estimées sur une base de données d'apprentissage $T\{(X, w_j)\}$.

En pratique, seules les lois gaussiennes sont envisagées ci-dessous, mais il est bien entendu que l'invention n'est pas limitée à ces lois, et la mise en oeuvre du procédé de l'invention avec d'autres lois sera aisée pour l'homme de l'art à la lecture de la présente description. En prenant les logarithmes des densités de probabilité, les fonctions caractéristiques sont de la forme :

$$h_j(X) = \{(X - \bar{X}_j)^t \Sigma^{-1} (X - X_j)\} + [Log |\Sigma| - 2 Log (p(W_j))]$$

soit $d_j(X)$ le premier terme de $h_j(X)$, qui n'est autre que la distance de Mahalanobis

$$d_j(X) = (X - \bar{X}_j)^t \Sigma^{-1} (X - \bar{X}_j)$$

Dans la plupart des cas, le deuxième terme de $h_j(X)$ est négligeable devant $d_j(X)$. En le négligeant, la fonction de décision devient particulièrement simple : on classe X dans la classe $W_j$ dont la distance $d_j(X)$ est la plus petite. Si les classes sont équiprobables, la surface séparatrice est un hyperplan.

Dans le cas de variables monodimensionnelles, cette séparatrice se ramène à un point X* représentant la séparatrice optimale entre les classes $W_1$ et $W_2$. Ces classes sont définies, dans le cas de lois de probabilité gaussiennes, par la moyenne et l'écart type de leurs individus.

On va maintenant examiner le cas d'une seule variable explicative (n=1). Dans le cas de deux classes définies chacune par une gaussienne monodimensionnelle, le point X* qui sépare optimalement les deux classes se détermine de la façon suivante :

$$d_1(X^*) = d_2(X^*)$$

$$\rightarrow \frac{(X^* - \overline{X}_1)^2}{\sigma_1^2} = \frac{(X^* - \overline{X}_2)^2}{\sigma_2^2}$$

On peut montrer très facilement que le point $X^*$ appartient au segment $[X_1 ; X_2]$. La formule ci-dessus se réécrit alors :

$$\frac{(X^* - \overline{X}_1)}{\sigma_1} = - \frac{(X^* - \overline{X}_2)}{\sigma_2}$$

$$\rightarrow X^* = \frac{\overline{X}_1 \cdot \sigma_2 + \overline{X}_2 \cdot \sigma_1}{\sigma_1 + \sigma_2}$$

Par analogie avec la mécanique on peut dire que le point $X^*$ représente le centre de gravité des points $X_1$ et $X_2$ de masse $\frac{1}{\sigma_1}$ et $\frac{1}{\sigma_2}$.

Ayant déterminé le point $X^*$, on découpe en deux sous-ensembles la base données $T(X, W_j)$ de la façon suivante :

$$\forall \ X_i \ \in T \ \left\{ \begin{array}{l} X_i \ \in T_1 \ si \ X_i \ \leq X^* \\ \\ X_i \ \in T_2 \ si \ X_i \ > X^* \end{array} \right.$$

Schématiquement, la procédure de segmentation se représente sous la forme d'un arbre dichotomique :

$$\text{Avec Card } \{T_1\} \ + \ \text{Card } \{T_2\} \ = \ \text{Card } \{T\}$$

Dans chacune des partitions de T, $T_1$ et $T_2$, on réitère la procédure en considérant que chaque segment fils obtenu à l'itération $\gamma$ devient segment père à l'itération $\gamma+1$ pour être partitionné à son tour en deux segments fils. Notons qu'un segment père ne pourra être découpé que si le nombre de classes est supérieur à deux de façon significative (chaque classe est suffisamment représentée).

Une telle procédure permet de construire un arbre de segmentation dichotomique où la variable explicative sélectionnée est toujours la même et où seule la valeur du seuil de segmentation est amenée à être modifiée.

Le procédé de l'invention peut être étendu au cas de plusieurs variables explicatives. On va d'abord décrire le choix de la variable explicative la plus discriminante. Si l'espace de représentation est de dimension p, il est nécessaire de choisir judicieusement la variable explicative suivant laquelle on partitionnera la population d'individus. La variable explicative sélectionnée doit offrir la meilleure discrimination possible au sens de l'analyse discriminante (minimisation de la variance à l'intérieur des classes et maximisation de la variance entre les classes).

On cherche, pour chaque variable explicative $X_j$, la valeur du seuil optimal $X^*_j$ (j=1, p), et on définit une nouvelle mesure $\omega^j_{12}$ permettant de chiffrer la discrimination apportée par la segmentation suivant la variable $X_j$ entre les classes $W_1$ et $W_2$.

$$\omega_{12}^{j} = \sum_{i=1}^{2} \sum_{x} P(X, W_i) \cdot \text{Log} \left( \frac{P(X|W_i)}{P(X)} \right)$$

avec

Log : logarithme népérien

X : individu bien classé par la segmentation

et

$$P(X, W_i) = \frac{N_{X, W_i}}{N}$$

$$P(X| W_i) = \frac{N_{X, W_i}}{N_i}$$

$$P(X) = \frac{N_X}{N}$$

N : Nombre total d'individus, toutes classes confondues

$N_X$ : Nombre d'individus bien classés toutes classes confondues

$N_i$ : Nombre total d'individus de la classe $W_i$

$N_{X,W_i}$ : Nombre d'individus de la classe $W_i$ bien classés

On calcule $\omega_{12}^{j}$ pour chaque variable $X^j$ et on sélectionne la variable $X^k$ pour laquelle $\omega_{12}^{k}$ est maximum :

$$\omega_{12}^{K} > _{12}^{j};$$

$\forall \, j \neq k \, (j = 1, p)$

Le nuage d'individus est segmenté suivant le seuil $X^*_k$ correspondant à la variable $X_k$. La représentation de ce partitionnement correspond au schéma ci-dessous :

Sur chacun des nouveaux segments fils, on réitère la procédure de la même façon.

On construit à l'aide de ce procédé un arbre de segmentation où à chaque niveau le nombre total d'individus est constant (population d'individus présents dans le segment père origine), mais où le nombre de représentants par segment fils est strictement inférieur au nombre d'individus contenus dans le segment père :

$$\text{Card} (\xi_1) + \text{Card} (\xi_2) = \text{Card} (\xi)$$

$$\text{Card}(\xi_i) < \text{Card}(\xi), (i = 1,2)$$

Comme c'est le cas en général dans toute segmentation, on fixe une limite à la segmentation par des tests d'arrêt.

On peut définir à l'aide de ces critères de segmentation une condition de découpage d'un segment quelconque S. Si sur l'ensemble des individus contenus dans le segment S, la variable descriptive présente une dichotomie de ses caractéristiques, on envisage de partager ce segment en deux segments fils ; mais, dans le cas où les individus des deux classes sont très mélangés, la segmentation n'apportant pas de discrimination supplémentaire, elle est inutile, voire néfaste.

On définit donc deux nouveaux critères $\omega_{12}^i$ et $\omega_{12}^f$ :

$\omega_{12}^i$ :     Critère initial, ou a priori, mesurant le mélange des classes dans le segment S.

$\omega_{12}^f$ :     Critère final, ou a posteriori, mesurant le mélange des classes sur l'ensemble des segments fils de S.

Ces critères s'énoncent :

$\omega_{12}^i$ :     Equivalent au critère $\omega_{12}$ défini pour le choix de la variable à segmenter.

$\omega_{12}^f$ :     Somme des critères $\omega_{12}$ sur l'ensemble des segments fils.

Ayant calculé ces deux critères, on teste la différence :

$$D = \left( \omega_{12}^f - \omega_{12}^i \right)$$

Pour que la segmentation ait un sens, il faut que D soit positif. Si ce n'est pas le cas, on ne traite pas le segment S qui devient alors segment terminal (on arrive à la "feuille" de la structure arborescente).

Le critère de division d'un segment est basé sur une réduction de l'impureté de ce segment. Si cette réduction est effective, on autorise la segmentation, sinon on déclare le segment terminal.

Néanmoins, la seule recherche de la réduction de l'impureté peut conduire à de très nombreuses divisions, l'arbre est très grand et donne, à la fin de la phase décisionnelle une probabilité de classement trop optimiste, loin du taux de classement réel obtenu avec la base de données de test en phase décisionnelle.

Pour éviter cela, une batterie de tests supplémentaires, connus en soi, complète le procédé de l'invention. Ce sont :

- seuil sur l'impureté acceptable pour un segment ;
- population minimale d'un segment (pourcentage de la population du segment origine) ;
- nombre maximal de segments ;
- nombre maximal de niveaux dans l'arbre de segmentation.

On remarquera que le procédé de l'invention étant basé sur une estimation paramétrique des densités de probabilité des différentes populations, le nombre d'individus présents dans un segment doit être suffisant pour que l'erreur sur l'estimation des paramètres ne soit pas trop importante.

Si un segment fils vérifie le test d'arrêt de la procédure, il est affecté à la classe de points majoritaires dans ce segment et devient segment terminal, il ne sera plus segmenté. La procédure est appliquée à un autre segment fils et se poursuit tant qu'il reste un segment non terminal.

Après le découpage d'un segment, on ne choisit pas de diviser systématiquement le segment contenant la partition complémentaire à celle précédemment traitée. On retient le segment qui donne la meilleure valeur du critère de discrimination $\omega_{12}^j$ défini ci-dessus.

Donc à l'itération $\gamma$, on dispose de K segments non terminaux, et on cherche pour segment la variable $X_j$, du seuil de segmentation $X^*$ et du critère $\omega_{12}^j$. On choisit de poursuivre la procédure à l'itération $\gamma+1$ en traitant le segment S tel que :

$$\omega_{12}^j(S) = \max_k \left[ \max_i \left[ \omega_{12}^i(S_k) \right] \right]$$

La phase d'apprentissage (ou phase descriptive) permet de construire un arbre de segmentation dichotomique. Un segment non terminal possède toujours deux segments fils définis à partir du segment père par seuillage sur une variable déterminée. A tout segment terminal est dédiée la classe unique ou la classe majoritaire des individus de ce segment.

Pour classer un nouvel individu on lui fait subir, depuis le segment originel, la série de tests correspondant à son cheminement dans l'arbre, et lorsqu'il tombe dans un segment terminal on lui attribue la classe correspondant à ce dernier segment.

Le procédé de l'invention, exposé ci-dessus dans le cas de deux classes peut être étendu aux problèmes multiclasses en considérant chaque classe vis-à-vis de toutes les autres.

Selon l'art antérieur, dans le cas de K classes présentes dans l'échantillon d'apprentissage, on construit K arbres de segmentation dichotomiques, où chaque segment père donne un segment fils dédié à la classe traitée, et un second segment fils dédié à toutes les autres classes confondues. La procédure d'apprentissage est alors moins rapide, ainsi que la phase décisionnelle. De plus, si chacune des K séquences est considérée indépendante des autres, les affectations peuvent être multiples : en effet si un individu est identifié comme appartenant à une classe déterminée, parce qu'il est tombé dans un segment terminal étiqueté comme partie de cette classe lors de la phase descriptive, rien ne s'oppose à ce qu'il subisse une identification différente lors d'une des K-1 phases décisionnelles qu'il devra subir. Si un tel cas se produit l'individu étant impossible à classer, on ne peut que le rejeter. Sur l'ensemble de la population test de nombreux objets peuvent ainsi être rejetés, entraînant une diminution sensible du pouvoir de discrimination.

Le procédé de l'invention est un procédé permettant de classer de façon unique un individu, ceci à partir d'un seul arbre de segmentation construit durant une seule phase d'apprentissage. L'arbre obtenu n'est plus dichotomique : chaque segment père est divisé en au moins autant de segments fils qu'il existe de classes significatives.

On va d'abord examiner le cas d'une seule variable. On a vu, dans le cas de deux classes que l'on peut séparer optimalement deux gaussiennes par le point X*, intersection de la séparatrice avec l'axe des barycentres des nuages d'individus.

Dans le cas de classes multiples, ce point $X^*_i$ est toujours compris dans le segment $[X_i, X_{i+1}]$, donc si on dénombre K classes, on peut déterminer les K-1 points $X^*_i$ (i=1, K-1) séparant deux à deux les classes $W_i$ et $W_{i+1}$ ordonnées suivant l'ordre croissant des barycentres $X_i$ (j=1, k) de chacune des K classes projetées sur la variable explicative $X_o$.

$$\begin{array}{cccc} W_1 & W_2 & W_i & W_K \end{array}$$

$$\text{———|————|——————} \ldots + \ldots \text{ ————|——}> X_o$$

$$X_1, \ \sigma_1 \quad X_2, \ \sigma_2 \qquad X_j, \ \sigma_i \quad X_K, \ \sigma_K$$

$$X_1 \leq X_2 \leq \ldots\ldots\ldots \leq X_i \leq \ldots\ldots\ldots \leq X_K$$

On réarrange donc les paramètres caractéristiques de la variable à expliquer de façon à satisfaire cet agencement des barycentres suivant la variable explicative $X_o$.

De la même façon que précédemment on détermine les seuils $X^*_i$ (i=1, K-1) par la formule :

$$X^*_i = \frac{\overline{X}_i \ \sigma_{i+1} + \overline{X}_{i+1} \ \sigma_i}{\sigma_i + \sigma_{i+1}}$$

La division de la population $\xi$ se faisant comme ci-dessous :

$$\forall X \in \xi \left\{ \begin{array}{ll} \text{si } X < X^*_1 & \text{alors } X \in \xi_1 \\ \text{si } X \geq X^*_{k-1} & \text{alors } X \in \xi_k \\ \text{si } X^*_{i-1} \leq X < X^*_1 & \text{alors } X \in \xi_i \quad i = 2, \ K-1 \end{array} \right.$$

On obtient ainsi K segments, correspondant aux K classes d'individus.

Le procédé de l'invention peut être étendu directement au cas multivariables. Si chaque individu est décrit par n

variables explicatives $x_j$ (j=1, n) dans $R^n$, on peut calculer pour chacune de ces variables le seuil optimal $X^*_j$. Il convient ensuite de choisir parmi ces n variables celle qui offre la meilleure discrimination possible. Cette descrimination est mesurée en lui associant un indice de précision interne du segment, qui mesure l'adéquation entre la partition, la variable explicative sélectionnée et la classe. Cette mesure est dérivée de l'indice $\omega^j_{12}$ défini précédemment, et étendue au cas multiclasses : $\omega^j_s$ : indice de précision interne du segment S suivant la variable explicative $X_j$.

$$\omega^j_{12} = \sum_{i=1}^{K} \sum_{X} P(X, W_i) \cdot Log \left( \frac{P(X|W_i)}{P(X)} \right)$$

K représente le nombre total de classes présentes dans le segment S. Le segment S est alors divisé en un nombre de segments fils correspondant au nombre de classes représentatives parmi les K classes représentées dans ce segment. Comme dans le cas dichotomique, la division suivante sera celle présentant l'indice de précision le plus fort.

On pratique le test d'arrêt de la façon suivante. Un segment fils sera terminal s'il vérifie le test d'arrêt défini dans le cas de deux classes (réduction de l'impureté, précision maximale, nombre minimal d'individus dans le segment). On lui affecte alors la classe des points majoritaires dans ce segment. La procédure se poursuit tant qu'il reste un segment non terminal.

Selon une variante du procédé de l'invention, on procède en découpant les segments pères suivant un nombre de segments fils supérieur au nombre de classes significatives, ceci pour tenir compte des modalités multiples d'une ou de plusieurs classes ou pour créer des segments de rejet dans lesquels on place les données trop confuses pour être segmentées de façon efficace.

Selon une autre variante, on adopte une autre définition mathématique du calcul des coupures optimales à partir de choix paramétriques différents, par exemple en mettant en oeuvre des lois de probabilités autres que les lois gaussiennes.

Selon encore une autre variante, on utilise des variables qualitatives préalablement recodées de façon numérique, par exemple en codant des couleurs par leur longueur d'onde, ou par exemple si on a des individus grands, moyens et petits, on attribue des valeurs numériques à leur surface ou à leur volume.

**Revendications**

1. Procédé de segmentation selon lequel on constitue une base de données à partir de plusieurs populations d'individus représentatives de classes d'individus à discriminer pour lesquels on utilise une loi statistique les définissant sur au moins une variable caractéristique, caractérisé en ce qu'après avoir ordonné sur un seul axe les populations pour chaque variable caractéristique, on segmente la base de données, en au moins autant de parties qu'il en apparaissait dans ladite base, de données, en fixant des coupures discriminant les classes ordonnées prises deux à deux en séparant à chaque fois deux classes voisines, on effectue cette séparation une fois moins que le nombre de classes, et on classe chaque nouvel individu dont on connaît la valeur de ses variables caractéristiques dans la classe la plus probable pour la partie où se trouve l'individu.

2. Procédé selon la revendication 1, caractérisé en ce que lorsque l'on ne dispose pas d'une loi statistique, on estime une loi à l'aide des données.

3. Procédé selon la revendication 1 ou 2, caractérisé par le fait que lorsque l'on dispose de plusieurs variables caractéristiques, on choisit celle offrant la meilleure discrimination possible entre classes par minimisation de la variance à l'intérieur des classes et maximisation de la variance entre classes.

4. Procédé selon la revendication 1, 2 ou 3, caractérisé par le fait que les coupures sont calculées à partir de la connaissance ou de l'estimation des paramètres descriptifs des lois statistiques voisines deux à deux.

5. Procédé selon l'une des revendications 1 à 4, caractérisé par le fait que la segmentation est effectuée tant qu'il reste des impuretés significatives dans les classes.

6. Procédé selon l'une des revendications précédentes, caractérisé par le fait que l'on effectue à chaque nouvelle segmentation au moins un test d'arrêt imposant l'arrêt de la segmentation dès que la réduction des impuretés

EP 0 552 575 B1

n'est plus effective.

7. Procédé selon la revendication 5, caractérisé par le fait que les tests d'arrêt comprennent au moins l'une des vérifications suivantes: seuil d'impureté acceptable pour une classe, population minimale d'une classe, nombre maximal de classes, nombre maximal de niveaux de segmentation.

8. Procédé selon l'une des revendications précédentes, caractérisé en ce qu'au cours de la segmentation on découpe les segments pères en un nombre de segments fils supérieur au nombre de classes significatives.

## Patentansprüche

1. Segmentierungsverfahren, gemäß dem ausgehend von mehreren Populationen von Individuen, die zu unterscheidende Klassen von Individuen repräsentieren, für die ein statistisches Gesetz verwendet wird, das sie für wenigstens eine charakteristische Variable definiert, eine Datenbank gebildet wird, dadurch gekennzeichnet, daß, nachdem die Populationen für jede charakteristische Variable auf einer einzigen Achse sequentiell angeordnet worden sind, die Datenbank in wenigstens so viele Teile, wie hiervon in der Datenbank auftreten, segmentiert wird, indem Schnitte festgelegt werden, die die sequentiell angeordneten Klassen paarweise unterscheiden, indem jedesmal zwei benachbarte Klassen getrennt werden, indem diese Trennung in einer Anzahl vorgenommen wird, die um eins kleiner als die Anzahl der Klassen ist, und indem jedes neue Individuum, wovon der Wert der charakteristischen Variablen bekannt ist, derjenigen Klasse zugeordnet wird, die für den Teil, in dem sich das Individuum befindet, die wahrscheinlichste ist.

2. Verfahren nach Anspruch 1, dadurch gekennzeichnet, daß, wenn kein statistisches Gesetz vorgesehen ist, ein Gesetz mit Hilfe der Daten geschätzt wird.

3. Verfahren nach Anspruch 1 oder 2, dadurch gekennzeichnet, daß, wenn mehrere charakteristische Variable vorgesehen sind, diejenige gewählt wird, die die bestmögliche Unterscheidung zwischen den Klassen durch Minimierung der Varianz in den Klassen und durch Maximierung der Varianz zwischen den Klassen bietet.

4. Verfahren nach Anspruch 1, 2 oder 3, dadurch gekennzeichnet, daß die Schnitte anhand der Kenntnis oder der Schätzung der deskriptiven Parameter der statistischen Gesetze, die paarweise benachbart sind, berechnet werden.

5. Verfahren nach einem der Ansprüche 1 bis 4, dadurch gekennzeichnet, daß die Segmentierung solange erfolgt, wie in den Klassen signifikante Verunreinigungen vorhanden sind.

6. Verfahren nach einem der vorangehenden Ansprüche, dadurch gekennzeichnet, daß bei jeder neuen Segmentierung wenigstens ein Beendigungstest ausgeführt wird, der die Beendigung der Segmentierung fordert, sobald die Reduzierung der Verunreinigungen nicht mehr wirksam ist.

7. Verfahren nach Anspruch 5, dadurch gekennzeichnet, daß die Beendigungstests wenigstens eine der folgenden Verifikationen umfassen: annehmbare Schwellenverunreinigung für eine Klasse, minimale Population einer Klasse, maximale Anzahl von Klassen, maximale Anzahl von Segmentierungsniveaus.

8. Verfahren nach einem der vorangehenden Ansprüche, dadurch gekennzeichnet, daß während der Segmentierung die Vater-Segmente in eine Anzahl von Sohn-Segmenten, die größer als die Anzahl der signifikanten Klassen ist, unterteilt werden.

## Claims

1. Segmentation process according to which a data base is made up from several populations of representative individual of classes of individuals to be discriminated for which a statistical law is available defining them on at least one characteristic variable, characterized in that after having ordered the populations for each characteristic variable over a single axis, the data base is segmented, into at least as many parts as there appeared thereof in said data base, by determining cuts discriminating the ordered classes taken two by two, each time separating two neighbouring classes, this separation is performed one time fewer than the number of classes, and each new

9

individual is classified whose value of its characteristic variables in the most probable class is known for the part where the individual is found.

2. Process according to Claim 1, characterized in that when a statistical law is not available, a law is estimated with the aid of the data.

3. Process according to Claim 1 or 2, characterized in that when several characteristic variables are available, the one is chosen which offers the best discrimination possible between classes by minimization of the variance inside the classes and maximization of the variance between classes.

4. Process according to Claim 1, 2 or 3, characterized in that the cuts are computed from the knowledge or from the estimation of the descriptive parameters of the pairwise neighbouring statistical laws.

5. Process according to one of Claims 1 to 4, characterized in that the segmentation is performed as long as significant impurities remain in the classes.

6. Process according to one of the preceding claims, characterized in that at each new segmentation at least one stop test is performed calling for the stopping of the segmentation as soon as the reduction of the impurities is no longer effective.

7. Process according to Claim 5, characterized in that the stop tests comprise at least one of the following verifications: acceptable impurity threshold for a class, minimum population of a class, maximum number of classes, maximum number of segmentation levels.

8. Process according to one of the preceding claims, characterized in that in the course of the segmentation the parent segments are split into a number of child segments greater than the number of significant classes.